(19) Europäisches Patentamt
European Patent Office
Office européen des brevets

(11) EP 1 768 467 A1

(12) **EUROPEAN PATENT APPLICATION**
published in accordance with Art. 158(3) EPC

(43) Date of publication:
**28.03.2007 Bulletin 2007/13**

(21) Application number: **05758316.3**

(22) Date of filing: **08.07.2005**

(51) Int Cl.:
***H05B 33/24*** *(2006.01)* ***H05B 33/12*** *(2006.01)*
***H05B 33/14*** *(2006.01)*

(86) International application number:
**PCT/JP2005/012666**

(87) International publication number:
**WO 2006/008987 (26.01.2006 Gazette 2006/04)**

(84) Designated Contracting States:
**DE FR GB**

(30) Priority: **15.07.2004 JP 2004208091**

(71) Applicant: **IDEMITSU KOSAN CO., LTD.**
**Tokyo 100-8321 (JP)**

(72) Inventors:
- **KATANO, Junichi**
**2990293 (JP)**
- **KUMA, Hitoshi**
**2990293 (JP)**

(74) Representative: **Gille Hrabal Struck Neidlein Prop Roos**
**Brucknerstrasse 20**
**40593 Düsseldorf (DE)**

(54) **ORGANIC EL DISPLAY**

(57) An organic electroluminescent display including: an organic electroluminescent device including an organic luminescent medium (4) which emits light having an emission peak wavelength λ1 of 400 to 500 nm, and a first reflecting member (2) and a second reflecting member (5b) disposed with the organic luminescent medium (4) placed therebetween; and a fluorescence conversion section (7) which absorbs the light emitted from the organic electroluminescent device and emits light having a wavelength differing from the wavelength of the light emitted from the organic electroluminescent device, the fluorescence conversion section having a maximum wavelength of λ2 in a range of 400 to 500 nm in an excitation spectrum; light emitted from the organic electroluminescent device being subjected to optical interference between the first reflecting member (2) and the second reflecting member (5b) so that an emission component having a wavelength λ3, which is closer to the wavelength λ2 than the wavelength λ1, is enhanced and emitted from the organic electroluminescent device.

FIG. 1

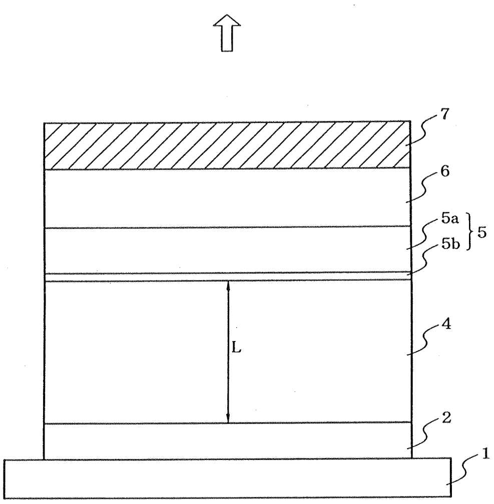




Printed by Jouve, 75001 PARIS (FR)

## Description

TECHNICAL FIELD

The invention relates to an organic electroluminescent (EL) display. More particularly, the invention relates to an organic EL display using an inorganic fluorescent material.

BACKGROUND ART

An organic EL display includes an organic EL device in which an organic luminescent medium is placed between opposing electrodes. When applying voltage between the electrodes of the organic EL device, electrons injected from one electrode and holes injected from the other electrode recombine in the organic luminescent medium. The organic luminescent molecules in the organic luminescent medium are excited by the recombination energy, and then return to the ground state from the excited state. The organic EL device emits the released energy as light.

When using an organic EL device which emits blue light, the blue light is converted into green light and red light using a fluorescence conversion material to realize a full color display. In recent years, an inorganic fluorescent material exhibiting high efficiency and durability has been proposed as the fluorescence conversion material in addition to an organic fluorescent material (for example, U.S.P. 6,501,091).

Such an inorganic fluorescent material generally has a short excitation wavelength of 460 nm or less. Therefore, in order to excite a fluorescence conversion section using such an inorganic fluorescent material, it is necessary to use a blue organic luminescent medium having a short peak wavelength. However, use of a blue organic luminescent medium having a short peak wavelength results in a problem such as a short continuous driving lifetime or a poor emission efficiency.

An object of the invention is to provide an organic EL device exhibiting high efficiency and having a long continuous driving lifetime.

DISCLOSURE OF THE INVENTION

As a result of extensive studies, the inventers of the invention found that, in an organic luminescent medium having an emission wavelength differing from the excitation wavelength of a fluorescence conversion section, emission from the medium can be enhanced by utilizing an optical interference effect so that the emission wavelength coincides with the fluorescence wavelength of the fluorescence conversion section. This finding has led to the completion of the invention.

The invention provides the following organic EL display.

1. An organic electroluminescent display comprising:

    an organic electroluminescent device including an organic luminescent medium which emits light having an emission peak wavelength λ1 of 400 to 500 nm, and a first reflecting member and a second reflecting member disposed with the organic luminescent medium placed therebetween; and

    a fluorescence conversion section which absorbs the light emitted from the organic electroluminescent device and emits light having a wavelength differing from the wavelength of the light emitted from the organic electroluminescent device, the fluorescence conversion section having a maximum wavelength of λ2 in a range of 400 to 500 nm in an excitation spectrum;

    light emitted from the organic electroluminescent device being subjected to optical interference between the first reflecting member and the second reflecting member so that an emission component having a wavelength λ3, which is closer to the wavelength λ2 than the wavelength λ1, is enhanced and emitted from the organic electroluminescent device.

2. The organic electroluminescent display according to 1, wherein the fluorescence conversion section includes an inorganic fluorescent material.

3. An organic electroluminescent display comprising: a blue pixel including,

a first organic electroluminescent device including an organic luminescent medium which emits blue light having an emission peak wavelength of λb;

a green pixel including,

a second organic electroluminescent device including an organic luminescent medium which emits blue light having an emission peak wavelength of λb, and a first reflecting member and a second reflecting member disposed with the organic luminescent medium placed therebetween and forming a first optical thickness, and

a green fluorescence conversion section which absorbs the blue light emitted from the second organic electroluminescent device and emits green light, the green fluorescence conversion section having a maximum peak wavelength in an excitation spectrum of λg,
light emitted from the organic luminescent medium being subjected to optical interference between the first reflecting member and the second reflecting member so that an emission component having a wavelength λb1, which is closer to the wavelength λg than the wavelength λb, is enhanced and emitted from the second organic electroluminescent device; and
a red pixel including,
a third organic electroluminescent device including an organic luminescent medium which emits blue light having an emission peak wavelength of λb, and a first reflecting member and a second reflecting member disposed with the organic luminescent medium placed therebetween and forming a second optical thickness, and
a red fluorescence conversion section which absorbs the blue light emitted from the third organic electroluminescent device and emits red light, the red fluorescence conversion section having a maximum peak wavelength in an excitation spectrum of λr,
light emitted from the organic luminescent medium being subjected to optical interference between the first reflecting member and the second reflecting member so that an emission component having a wavelength λb2, which is closer to the wavelength λr than the wavelength λb, is enhanced and emitted from the third organic electroluminescent device.

4. The organic electroluminescent display according to 3, wherein the red fluorescence conversion section and the green fluorescence conversion include an inorganic fluorescent material.

5. The organic electroluminescent display according to 3, comprising an optical thickness adjustment layer between the first reflecting member and the second reflecting member forming the first optical thickness or between the first reflecting member and the second reflecting member forming the second optical thickness.

6. An organic electroluminescent display comprising:

a blue pixel including,
a first organic electroluminescent device including an organic luminescent medium which emits blue light having an emission peak wavelength of λb, and a first reflecting member and a second reflecting member disposed with the organic luminescent medium placed therebetween and forming a first optical thickness,
light emitted from the organic luminescent medium being subjected to optical interference between the first reflecting member and the second reflecting member so that a blue emission component is enhanced and emitted from the first organic electroluminescent device;
a green pixel including,
a second organic electroluminescent device including an organic luminescent medium which emits blue light having an emission peak wavelength of λb, and a first reflecting member and a second reflecting member disposed with the organic luminescent medium placed therebetween and forming a second optical thickness, and
a green fluorescence conversion section which absorbs the blue light emitted from the second organic electroluminescent device and emits green light, the green fluorescence conversion section having a maximum peak wavelength in an excitation spectrum of λg,
light emitted from the organic luminescent medium being subjected to optical interference between the first reflecting member and the second reflecting member so that an emission component having a wavelength λb1, which is closer to the wavelength λg than the wavelength λb, is enhanced and emitted from the second organic electroluminescent device; and
a red pixel including,
a third organic electroluminescent device including an organic luminescent medium which emits blue light having an emission peak wavelength of λb, and a first reflecting member and a second reflecting member disposed with the organic luminescent medium placed therebetween and forming a third optical thickness, and
a red fluorescence conversion section which absorbs the blue light emitted from the third organic electroluminescent device and emits red light, the red fluorescence conversion section having a maximum peak wavelength in an excitation spectrum of λr,
light emitted from the organic luminescent medium being subjected to optical interference between the first reflecting member and the second reflecting member so that an emission component having a wavelength λb2, which is closer to the wavelength λr than the wavelength λb, is enhanced and emitted from the third organic electroluminescent device.

7. The organic electroluminescent display according to 6, wherein the red fluorescence conversion section and the green fluorescence conversion include an inorganic fluorescent material.

8. The organic electroluminescent display according to 6, comprising a first optical thickness adjustment layer

between the first reflecting member and the second reflecting member forming the second optical thickness, and a second optical thickness adjustment layer between the first reflecting member and the second reflecting member forming the third optical thickness.

9. The organic electroluminescent display according to any of 1 to 8, further comprising a substrate, the organic electroluminescent display being a top emission type in which light is taken out from a side opposite to the substrate.

10. The organic electroluminescent display according to any of 1 to 8, further comprising a substrate, the organic electroluminescent display being a bottom emission type in which light is taken out from a side of the substrate.

According to the invention, an organic EL device exhibiting high efficiency and having a long continuous driving lifetime can be provided.

BRIEF DESCRIPTION OF THE DRAWINGS

FIG. 1 is a diagram showing one embodiment of an organic EL display according to the invention.

FIG. 2(a) is a diagram showing an emission spectrum of an organic luminescent medium and an excitation spectrum of a fluorescence conversion section before being subjected to an optical interference effect.

FIG. 2(b) is a diagram showing an emission spectrum of an organic luminescent medium and an excitation spectrum of a fluorescence conversion section after being subjected to an optical interference effect.

FIG. 3 is a diagram showing another embodiment of the organic EL display according to the invention.

FIG. 4 is a diagram showing another embodiment of the organic EL display according to the invention.

FIG. 5 is a diagram showing yet another embodiment of the organic EL display according to the invention.

BEST MODE FOR CARRYING OUT THE INVENTION

First Embodiment

FIG. 1 is a view showing one embodiment of an organic EL display according to the invention, in which a first reflecting electrode 2 (first reflecting member), an organic luminescent medium 4, a second reflecting electrode 5, a solid sealing layer 6, and a fluorescence conversion section 7 are stacked on a substrate 1 in that order. The reflecting electrode 5 includes a metal film 5b (second reflecting member) and a transparent electrode 5a. One of the reflecting electrodes 2 and 5 functions as an anode, and the other functions as a cathode. The arrow indicates the direction in which light is taken out (top emission type).

The first reflecting electrode 2, the organic luminescent medium 4, and the second reflecting electrode 5 form an organic EL device. L schematically indicates the optical thickness between the reflecting electrodes 2 and 5 of the organic EL device. The optical thickness is a product of the actual thickness and the refractive index, which will be described later. The organic luminescent medium 4 emits blue light with an emission spectrum A having an emission peak wavelength of λ1, as shown in FIG. 2(a). As shown in FIG. 2(a), the maximum peak wavelength of an excitation spectrum B of the fluorescence conversion section 7 is λ2.

The operation of the organic EL display is described below.

The organic luminescent medium 4 emits blue light having an emission peak wavelength of λ1 as shown in FIG. 2(a). The blue light is subjected to optical interference by being repeatedly reflected between the reflecting electrodes 2 and 5 so that light having an emission spectrum A', in which an emission component having a wavelength of λ3, which is approximately equal to the wavelength λ2, is enhanced as shown in FIG. 2(b), is emitted from the device.

Since the fluorescence conversion section 7 receives light of which the wavelength λ3 is enhanced from the device, the section 7 is efficiently excited and converts the blue light.

The fluorescence conversion section 7 may include either an organic fluorescent material or an inorganic fluorescent material. An inorganic fluorescent material generally has a short wavelength of 460 nm or less. Therefore, the invention is effective for a device using an inorganic fluorescent material and a blue light emitting medium having a long peak wavelength.

The organic EL device has an optical resonator structure in which a resonator is formed between the reflective electrode 2 and the metal layer 5b. The optical resonator structure allows light generated by the organic luminescent medium 4 to be repeatedly reflected between the reflecting surfaces (reflective electrode 2 and metal layer 5b), so that light around a wavelength satisfying the following equation (1) is selectively enhanced and emitted from the device.

$$(2L)/\lambda+\Phi/(2\pi)=m \qquad (1)$$

where L indicates the optical length of the resonator, $\lambda$ indicates the wavelength of the light, $\Phi$ indicates the sum of phase shifts at the interface between the two reflecting members, and m indicates an integer of zero or more.

The optical length L is the product of the refractive index n and the actual geometrical length $L_R$ of the medium through which the light passes. The optical length L is calculated as follows.
Specifically, a thin film of the material forming the organic luminescent medium 4 is formed on a supporting substrate. The resulting thin film sample is subjected to optical measurement using an ellipsometer or the like to determine the refractive index n of the material.
In FIG. 1, only the organic luminescent medium 4 is provided between the electrodes 2 and 5 so that the invention is readily understood. Note that the organic EL device generally further includes an electron-injecting layer, an electron-transporting layer, a hole-injecting layer, a hole-transporting layer, and the like, and these layers form an organic layer. When two or more layers are provided between the reflecting members, the optical length L is determined by calculating the product of the thickness d and the refractive index n of each layer, and calculating the sum of the products.

The sum $\Phi$ of the phase shifts is calculated as follows.
The sum $\Phi$ of the phase shifts is expressed by the following equation.

$$\Phi=\Phi_1+\Phi_2 \qquad (2)$$

$\Phi_1$ is calculated as follows. Specifically, the reflective electrode 2 is formed on a supporting substrate. The resulting thin film is subjected to optical measurement using an ellipsometer or the like to determine the refractive index no and the extinction coefficient $k_0$ of the material. $\Phi_1$ is calculated by the following equation (3). In the equation (3), $n_1$ indicates the refractive index of the material for the layer in contact with the reflective electrode 2 on the side of the metal film 5b.

$$\Phi_1 = \arctan\left(\frac{2n_1\kappa_0}{n_1^{\,2}-n_0^{\,2}-\kappa_0^{\,2}}\right) \qquad (3)$$

$\Phi_2$ is also calculated by the equation (3) after calculating the refractive index and the extinction coefficient of the metal film 5b and the refractive index of the material for the layer in contact with the metal film 5b on the side of the reflective electrode 2.

The optical length L may be adjusted by the refractive index and the thickness of one or more layers including at least the organic luminescent medium present between the reflecting surfaces. The optical length L may also be adjusted by providing an optical thickness adjustment layer such as an inorganic compound layer.

The reflecting electrode 2 and the metal film 5b are conductive films having a function of reflecting light emitted from the organic luminescent medium 4, and generally have a reflectance of 10% or more. In the first embodiment, it is preferable that the reflectance of the metal film 5b be lower than that of the first reflecting electrode 2 so that light from the organic luminescent medium 4 is emitted through the second reflecting electrode 5. For example, the reflectance of the reflecting electrode 2 is 50% or more, and preferably 70% or more, and the reflectance of the metal film 5b is 25% or more. It is preferable that the reflecting electrode 2, which is farther away from the fluorescence conversion section 7 than the metal film 5b, be thicker than the metal film 5b.

The reflectance of the reflecting electrode (or metal film) used herein refers to a value determined by the following method. A mirror having a known reflectance (e.g. magnesium fluoride/aluminum stacked mirror) is provided. The reflectance of the mirror is indicated by $R_0$. The reflection intensity of the mirror is measured with a reflection type microscopic spectrometer using a tungsten lamp or the like as a light source. The resulting reflection intensity of the mirror is indicated by $I_0$. The reflection intensity of the reflecting electrode is measured in the same manner as described above. The resulting reflection intensity of the reflecting electrode is indicated by $I_{el}$. The reflectance R of the reflecting electrode is calculated by the following equation (4).

$$R = R_0 \times (I_{el}/I_0) \qquad (4)$$

In the first embodiment, the metal layer 5b is provided between the transparent electrode 5a and the organic luminescent medium 4 as the second reflecting member. The metal layer 5b may be stacked on the transparent electrode 5a, or an additional layer may be provided between the metal layer 5b and the organic luminescent medium 4. An insulator (e.g. dielectric multilayer film) other than the metal layer may be used as the second reflecting member, as described later.

The first reflecting member and the electrode need not be a single member. The first reflecting member and the electrode may be separated in that order in the light-taking-out direction, or may be stacked in the order of the insulating reflecting layer and the electrode in the light-taking-out direction. As a specific example of the insulating reflecting layer, a multilayer stacked film including a high-refractive-index dielectric layer and a low-refractive-index dielectric layer (known as a dielectric laser mirror) can be given. As examples of the material for the high-refractive-index dielectric layer, metal oxides such as $ZrO_2$, $CeO_2$, and $Ta_2O_3$ and II-VI compounds such as ZnS and CdS can be given. As examples of the material for the low-refractive-index dielectric layer, metal fluorides such as $CaF_2$ and $AlF_3$ can be given.

Second Embodiment

FIG. 3 is a diagram showing another embodiment of the organic EL display according to the invention.
In the drawings, the same members as the members shown in FIG. 1 are indicated by the same symbols. Description of these members is omitted.
In the organic EL display shown in FIG. 3, the first reflecting electrode (first reflecting member) 2, an optical thickness adjustment layer 3, the organic luminescent medium 4, the second reflecting electrode 5, and the solid sealing layer 6 are stacked on the substrate 1 in that order. A green fluorescence conversion section 7G, a red fluorescence conversion section 7R, and a transparent layer 8 are provided on the solid sealing layer 6. The reflecting electrode 5 includes the metal film 5b (second reflecting member) and the transparent electrode 5a.

The first reflecting electrode 2, the organic luminescent medium 4, and the transparent electrode 5a form a first organic EL device. The first reflecting electrode 2, the organic luminescent medium 4, and the second reflecting electrode 5 form a second organic EL device. The first reflecting electrode 2, the optical thickness adjustment layer 3, the organic luminescent medium 4, and the second reflecting electrode 5 form a third organic EL device. LG schematically indicates the optical thickness between the reflecting electrodes 2 and 5 of the second organic EL device, and LR schematically indicates the optical thickness between the reflecting electrodes 2 and 5 of the third organic EL device.

A blue pixel I is formed by the first organic EL device, the solid sealing layer 6, and the transparent layer 8. A green pixel II is formed by the second organic EL device, the solid sealing layer 6, and the green fluorescence conversion section 7G. A red pixel III is formed by the third organic EL device, the solid sealing layer 6, and the red fluorescence conversion section 7R.

The operation of the organic EL display is described below.
The organic luminescent medium 4 emits blue light.
In the blue pixel I, the light emitted from the organic luminescent medium 4 passes through the transparent electrode 5a and is emitted to the outside through the transparent layer 8.
In the green pixel II, the blue light from the second reflecting electrode 5 is converted into green light by the green fluorescence conversion section 7G and emitted to the outside.
In the red pixel III, the blue light from the second reflecting electrode 5 is converted into red light by the red fluorescence conversion section 7R and emitted to the outside.
A full color device is realized by these pixels.
The peak wavelength of the emission spectrum of the blue light is preferably in the range from 400 to 500 nm, the peak wavelength of the emission spectrum of the green light is preferably in the range from 500 to 550 nm, and the peak wavelength of the emission spectrum of the red light is preferably in the range from 550 to 650 nm.

In the green pixel II, the optical thickness LG of the second organic EL device is adjusted so that light of the wavelength corresponding to the excitation wavelength of the fluorescence conversion section 7G is enhanced. In the red pixel III, the optical thickness LR of the third organic EL device is adjusted so that light of the wavelength corresponding to the excitation wavelength of the fluorescence conversion section 7R is enhanced by the optical thickness adjustment layer 3. Therefore, when the light emitted from the organic luminescent medium 4 is repeatedly reflected between the reflecting electrode 2 and the metal film 5b, light of the wavelengths corresponding to the excitation wavelengths of the fluorescence conversion sections 7G and 7R are enhanced by multiple optical interference, and the resulting light is emitted through the reflecting electrode 5. As a result, the fluorescence conversion sections 7G and 7R are efficiently

excited so that the emission efficiency of the fluorescence conversion sections 7G and 7R is increased.

Blue, green, and red color filters may be respectively provided in the pixels I, II, and III.

Third Embodiment

FIG. 4 is a diagram showing another embodiment of the organic EL display according to the invention. This organic EL display differs from the organic EL display according to the second embodiment as to the configurations of the blue pixel I and the green pixel II.
Specifically, the metal film 5b is also provided in the blue pixel I, so that a resonator having an optical thickness of LB is formed between the reflecting electrodes 2 and 5 to allow optical interference to occur. Therefore, blue light with a desired wavelength being enhanced is obtained.
In the green pixel II, an optical thickness adjustment layer 3a corresponding to the peak wavelength of the excitation spectrum of the green fluorescence conversion section 7G is provided. Therefore, the green fluorescence conversion section 7G and the red fluorescence conversion section 7R are efficiently excited in the same manner as in the second embodiment.
The optical thickness adjustment layer 3a of the green pixel II may be omitted when light emitted from the first organic EL device corresponds to the excitation wavelength peak of the green fluorescence conversion section 7G.

Fourth Embodiment

FIG. 5 is a diagram showing yet another embodiment of the organic EL display according to the invention.
In the organic EL display shown in FIG. 5, the fluorescence conversion sections 7G and 7R and the transparent layer 8, the second reflecting electrode 5, the optical thickness adjustment layers 3a and 3b, the organic luminescent medium 4, the first reflecting electrode 2, and the solid sealing layer 6 are stacked on the substrate 1 in that order. This organic EL display differs from the organic EL display according to the third embodiment as to the configurations of the optical thickness adjustment layers 3a and 3b, the positions of the fluorescence conversion sections 7G and 7R and the transparent layer 8, and the light-taking-out direction.

In the third embodiment, the optical thicknesses are adjusted by changing the thicknesses of the optical thickness adjustment layers 3a and 3b formed of the same material. In the fourth embodiment, the optical thickness adjustment layers 3a and 3b are formed of different materials and have the same thickness.
In the fourth embodiment, light emitted from the organic luminescent medium 4 passes through the transparent layer 8 or subjected to color conversion by the fluorescence conversion sections 7G and 7R, and is emitted through the substrate 1 (bottom emission type). In the green and red pixels II and III, the fluorescence conversion sections 7G and 7R are efficiently excited by adjusting the optical thicknesses LG and LR in the same manner as in the third embodiment.
In the fourth embodiment, the reflectance of the first reflecting electrode 2 is increased.

In the fourth embodiment, the fluorescence conversion sections 7G and 7R and the transparent layer 8 are formed between the substrate and the organic EL device. The fluorescence conversion sections 7G and 7R and the transparent layer 8 may also be formed on the opposite side of the substrate 1 (on the side in the light-taking-out direction).

Each member is described below.

1. Reflective electrode

As the material for the reflective electrode, a metal film having low optical transparency is preferable. The reflectance of the metal film is determined by the thickness d, complex refractive index n-ik, and surface roughness (RMS surface roughness) o. As the material for the metal film, a material of which both of the real part n and the imaginary part κ (corresponding to the absorption coefficient) of the complex refractive index are small is preferable. As specific examples of such a material, Au, Ag, Cu, Mg, Al, Ni, Pd, and the like can be given.

If the thickness d is small, since light passes through the metal film, the reflectance decreases. It is preferable that the thickness of the metal film be 50 nm or more, although the thickness varies depending on the value of the imaginary part K of the complex refractive index of the metal used.

If the surface roughness σ is great, light undergoes diffused reflection so that the amount of components reflected in the direction perpendicular to the emission surface of the organic EL device decreases. Therefore, the surface roughness σ is preferably less than 10 nm, and still more preferably less than 5 nm.

As the first and second reflective electrodes, the following (1) to (4) can be given.

(1) Metal electrode

An electrode formed of a metal which reflects light, such as Au, Ag, Al, Pt, Cu, W, Cr, Mn, Mg, Ca, Li, Yb, Eu,

Sr, Ba, or Na, or an alloy of two or more metals arbitrarily selected from these metals, such as Mg:Ag, Al:Li, Al:Ca, or Mg:Li, can be given. Of these, a metal or alloy having a work function of 4.0 eV or less is preferable as the cathode, and a metal or alloy having a work function of 4.5 eV or more is preferable as the anode.
The metal electrode can function as a light reflecting member and an electrode.

(2) Stacked electrode of metal film /transparent electrode or transparent electrode/metal film

Since a transparent electrode itself has a low reflectance, the reflectance can be increased by stacking the transparent electrode and a metal film. As the material for the transparent electrode, a conductive oxide is preferable. In particular, ZnO:Al, indium tin oxide (ITO), $SnO_2$:Sb, InZnO, and the like are preferable. As the metal film, a film made of the metal or alloy described in (1) is preferably used. In the stacked electrode, either the transparent electrode or the metal film may be arranged in the side contacting the organic layer.
The metal film can function as a light reflecting member and an electrode.

(3) Stacked electrode of dielectric film/transparent electrode (metal film) or transparent electrode (metal film)/dielectric film

Since a transparent electrode itself has a low reflectance as described above, the reflectance can be increased by stacking the transparent electrode and a high-refractive-index or low-refractive-index dielectric film. As the high-refractive-index dielectric film, a transparent oxide film or a transparent nitride film having a refractive index of 1.9 or more is preferable. A transparent sulfide film or selenide compound film is also preferable.
The metal film described in (1) can be used instead of the transparent electrode.
The dielectric film mainly functions as a light reflecting member.
As examples of the high-refractive-index dielectric film, films formed of ZnO, $ZrO_2$, $HfO_2$, $TiO_2$, $Si_3N_4$, BN, GaN, GaInN, AlN, $Al_2O_3$, ZnS, ZnSe, ZnSSe, and the like can be given. A film formed by dispersing a powder of such a compound in a polymer may also be used.
As examples of the low-refractive-index dielectric film, a transparent oxide film or a transparent fluoride film having a refractive index of 1.5 or less, a film formed by dispersing a powder of such an oxide or fluoride in a polymer, a fluoropolymer film, and the like can be given. Specific examples include a film formed of $MgF_2$, $CaF_2$, $BaF_2$, NaAlF, SiOF, or the like, a film formed by dispersing a powder of such a compound in a polymer, and a film formed of a fluorinated polyolefin, fluorinated polymethacrylate, fluorinated polyimide, and the like.

(4) Stacked electrode of dielectric multilayer film/transparent electrode (metal film) or transparent electrode (metal film) / dielectric multilayer film

The dielectric multilayer film in this stacked electrode is a film formed by alternately stacking the high-refractive-index dielectric film and the low-refractive-index dielectric film described in (3) a number of times. As the transparent electrode, the transparent electrode described in (2) can be given. As the metal film, the metal film described in (1) can be given.
The dielectric multilayer film mainly functions as a light reflecting member.
It is preferable that the reflective electrode has a work function of 4.5 eV or more when used as the anode. As examples of the material for the anode, indium tin oxide (ITO), indium zinc oxide (IZO), tin oxide (NESA), gold, silver, platinum, copper and the like can be given. Of these, indium zinc oxide (IZO) is particularly preferable, since IZO film can be formed at room temperature and is highly amorphous so that separation of the anode hardly occurs. The sheet resistance of the anode is preferably 1000 Ω/square or less.
When using the reflective electrode as the cathode, an electrode formed of a metal, alloy or electrically conductive compound having a small work function (4 eV or less), or a mixture of these materials is used. As specific examples of such an electrode material, sodium, a sodium-potassium alloy, magnesium, lithium, a magnesium-silver alloy, aluminum/aluminum oxide, an aluminum-lithium alloy, indium, a rare earth metal, and the like can be given. The sheet resistance of the cathode is preferably several hundred Ω/square or less.
In the invention, it is particularly preferable that one of the pair of reflecting members include a multilayered structure of the dielectric film and the transparent electrode or the dielectric multilayer film. The reflecting member may be formed by using a deposition method or a sputtering method, for example. As examples of the deposition method, a resistance heating method, an electron beam method, and the like can be given. As examples of the sputtering method, a DC sputtering method, an ion beam sputtering method, an electron cyclotron resonance (ECR) method, and the like can be given.

2. Substrate

When the substrate is provided in the light-taking-out path, a substrate having optical transparency is used. As examples of such a substrate, substrates formed of glass, quartz, an organic polymer compound, and the like can be given. Of these, a substrate having a refractive index of 1.6 or less is preferable.

3. Optical thickness-adjusting layer

The optical thickness-adjusting layer is a layer which adjusts the optical thickness between the two reflecting members and is made of a substance transparent to visible light (having a visible light transmittance of 50% or more, and preferably 80% or more).
The material used for the optical thickness-adjusting layer is not particularly limited insofar as the material is transparent. For example, an inorganic oxide is preferable. As specific examples of the inorganic oxide, oxides of In, Sn, Zn, Ce, Sm, Pr, Nd, Tb, Cd, Al, Mo, W, and the like can be given. Of these, an oxide containing In, Sn, Zn, or Ce is preferable.

4. Organic layer

An organic layer arranged between the pair of reflecting members includes at least an organic luminescent medium. The following configurations can be given as examples of the configuration from the reflective electrode as the anode to the reflective electrode as the cathode.

(1) Hole-injecting layer/organic luminescent medium
(2) Hole-transporting layer/organic luminescent medium
(3) Organic luminescent medium/electron-injecting layer
(4) Hole-injecting layer/organic luminescent medium/electron-injecting layer
(5) Hole-transporting layer/organic luminescent medium/electron-injecting layer
(6) Hole-injecting layer/hole-transporting layer/organic luminescent medium/electron-injecting layer
(7) Hole-injecting layer/organic luminescent medium/hole barrier layer/electron-injecting layer
(8) Hole-injecting layer/organic luminescent medium/electron-injecting layer/adhesion-improving layer
(9) Hole-transporting layer/organic luminescent medium/adhesion-improving layer
(10) Hole-injecting layer/electron barrier layer/organic luminescent medium/electron-injecting layer

Of these configurations, the "hole-transporting layer/organic luminescent medium" configuration, the "hole-transporting layer/organic luminescent medium/electron-injecting layer" configuration, and the "hole-transporting layer/organic luminescent medium/adhesion-improving layer" configuration are preferable. The organic layer may include an inorganic compound layer, if necessary.
The organic luminescent medium described above can be formed by a known method such as vapor deposition, spin coating, casting process or LB technique. In particular, the organic luminescent medium is preferably a molecule-deposited film. The molecule-deposited film is a thin film formed by precipitation and deposition from a compound for the organic luminescent medium in a gas phase state or a film formed by solidification from the compound in a molten state or a liquid phase state. This molecule-deposited film can be usually distinguished from the thin film formed by LB technique (the molecule-accumulated film) by difference in aggregation structure or high-order structure, or in functional difference resulting therefrom. The organic luminescent medium can be formed by dissolving a compound for the organic luminescent medium together with a binder such as resin into a solvent to prepare a solution and then making this into a thin film by spin coating or the like.
The organic luminescent medium is preferably formed by doping a dopant in a host material. It is preferred to use, as the host material, a material represented by a general formula (1):
$$\left(Ar^1\right)_l \left(X\right)_m \qquad (1)$$

wherein $Ar^1$ is an aromatic ring with 6 to 50 nucleus carbon atoms, X is a substituent, 1 is an integer of 1 to 5, and m is an integer of 0 to 6.
Specific examples of $Ar^1$ include phenyl, naphthyl, anthracene, biphenylene, azulene, acenaphthylene, fluorene, phenanthrene, fluoranthene, acephenanthrylene, triphenylene, pyrene, chrysene, naphthacene, picene, perylene,

penthaphene, pentacene, tetraphenylene, hexaphene, hexacene, rubicene, coronene, and trinaphthylene rigns.

Specific examples of X include substituted or unsubstituted aromatic groups with 6 to 50 nucleus carbon atoms, substituted or unsubstituted aromatic heterocyclic groups with 5 to 50 nucleus atoms, substituted or unsubstituted alkyl groups with 1 to 50 carbon atoms, substituted or unsubstituted alkoxy groups with 1 to 50 carbon atoms, substituted or unsubstituted aralkyl groups with 1 to 50 carbon atoms, substituted or unsubstituted aryloxy groups with 5 to 50 nucleus atoms, substituted or unsubstituted arylthio groups with 5 to 50 nucleus atoms, substituted or unsubstituted carboxyl groups with 1 to 50 carbon atoms, substituted or unsubstituted styryl groups, halogen groups, a cyano group, a nitro group, and a hydroxyl group.

1 of $Ar^1$s may be the same or different when 1 is 2 or more, and m of Xs may be the same or different when m is 2 or more.

It is preferred to use, as the dopant, a material represented by a general formula (2):

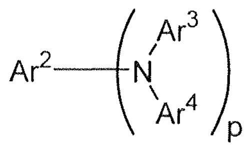

(2)

wherein $Ar^2$ to $Ar^4$ are each a substituted or unsubstituted aromatic group with 6 to 50 nucleus carbon atoms, or a substituted or unsubstituted styryl group, and p is an integer of 1 to 4.

Examples of the substituted or unsubstituted aromatic group with 6 to 50 nucleus carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-talyl, m-tolyl, p-tolyl, p-t-butylphenyl, p-(2-phenylpropyl)phenyl, 3-methyl-2-naphthyl, 4-methyl-1-naphthyl, 4-methyl-1-anthryl, 4'-methylbiphenylyl, 4"-t-butyl-p-terphenyl-4-yl, 2-fluorenyl, 9,9-dimethyl-2-fluorenyl and 3-fluorantenyl groups.

Examples of the substituted or unsubstituted styryl group include 2-phenyl-1-vinyl, 2,2-diphenyl-1-vinyl, and 1,2,2-triphenyl-1-vinyl groups.

p is an integer of 1 to 4.
p of $Ar^3$s, as well as p of $Ar^4$s, may be the same or different, respectively, when p is 2 or more.

Next, the hole-transporting layer is not essential, but it is preferably used to improve a luminous performance. Such a hole-transporting layer is preferably made of a material which can transport holes to the organic luminescent medium at a lower electric field intensity. The hole mobility thereof is preferably at least $10^{-6}$ $cm^2/V \cdot$second when an electric field of, e.g., $10^4$ to $10^6$ V/cm is applied. The material for the hole-transporting layer is not particularly limited so long as the material has the above-mentioned preferred natures. The material can be arbitrarily selected from materials which have been widely used as a hole-transporting material in photoconductive materials and known materials used in a hole-transporting layer of organic EL devices.

The hole-transporting layer can be formed by making the hole-transporting material into a thin film by a known method such as vacuum deposition, spin coating, casting or LB technique.
The thickness of the hole-transporting layer is not particularly limited, and is usually from 5 nm to 5 μm. This hole-transporting layer may be a single layer made of one or more out of the hole-transporting materials. The hole-transporting layer may be formed by stacking plural hole-transporting layers made of different materials.

Between the organic luminescent medium and the anode, an electron barrier layer may be formed to keep electrons in the organic luminescent medium.
Between the organic luminescent medium and the cathode, a hole barrier layer may be formed to keep holes in the organic luminescent medium.

The electron-injecting layer, which is made of electron-injecting materials, has a function for transporting electrons injected from the cathode to the organic luminescent medium. The electron-injecting material is not particularly limited. The material can be arbitrarily selected from compounds which have been widely known.
The electron-injecting layer can be formed by making the electron-injecting material into a thin film by a known method, such as vacuum deposition, spin coating, casting or LB technique.
The thickness of the electron-injecting layer is usually from 5 nm to 5 μm. This electron-injecting layer may be a single layer made of one or more out of the electron-injecting materials. Alternatively, it may be constituted by stacking plural electron-injecting layers each made of a material different from each other.

The adhesion-improving layer preferably includes a material good in electron-transmittance, and adhesion to

an organic luminescent medium and the cathode. Specific examples of such materials include metal complexes of 8-hydroxyquinoline or derivative thereof such as metal chelate oxynoid compounds each containing a chelate of oxine (generally, 8-quinolinol or 8-hydroxyquinoline). Specifically, examples thereof include tris(8-quinolinol)aluminum, tris (5,7-dichloro-8-quinolinol)aluminum, tris(5,7-dibromo-8-quinolinol)aluminum and tris(2-methyl-8-quinolinol)aluminum, and complexes thereof with metals such as indium, magnesium, copper, gallium, tin and lead instead of aluminum.

5. Fluorescence conversion section

A fluorescence conversion section is arranged outside the light-taking-out-side reflective electrode in order to change the color of the light emitted from the organic layer and having a center wavelength of $\lambda$. The color conversion member is formed of a fluorescent material. Inorganic fine particles are preferred since they have deterioration resistance and exhibit excellent durability compared to organic fine particles. The fine particles absorbing and emitting visible light utilizing band gap of semiconductor mentioned later are preferred since they exhibit even excellent luminous efficiency.
The fluorescence conversion section may be formed by mixing fluorescent material fine particles and a matrix resin.
As the fluorescent material fine particles, inorganic fluorescent material fine particles and organic fluorescent material fine particles given below may be used, for example.
As the inorganic fluorescent material fine particle, a fine particle containing an inorganic compound such as a metal compound which absorbs visible light and emits fluorescence having a wavelength longer than that of the absorbed light, may be used. The surface of the fine particle may be modified with an organic substance such as a long-chain alkyl group or phosphoric acid in order to increase the dispersibility in the matrix resin described later.
Specific examples of the fine particles are given below.

(a) Fine particles produced by doping metal oxide with transition metal ion

Fine particles produced by doping a metal oxide such as $Y_2O_3$, $Gd_2O_3$, ZnO, $Y_3Al_5O_{12}$, or $Zn_2SiO_4$ with a transition metal ion which absorbs visible light, such as $Eu^{2+}$, $Eu^{3+}$, $Ce^{3+}$, or $Tb^{3+}$, may be used

(b) Fine particles produced by doping metal chalcogenide with transition metal ion

Fine particles produced by doping a metal chalcogenide such as ZnS, CdS or CdSe with a transition metal ion which absorbs visible light, such as $Eu^{2+}$, $Eu^{3+}$, $Ce^{3+}$, or $Tb^{3+}$, may be used. In order to prevent S, Se, or the like from being removed by a reaction component of the matrix resin described later, the surface of the particle may be modified with a metal oxide such as silica or an organic substance, for example.

(c) Fine particles absorbing and emitting visible light utilizing band gap of semiconductor

Semiconductor fine particles such as CdS, CdSe, CdTe, ZnS, ZnSe, and InP may be used. As known from the literature such as JP-A-2002-510866, the band gap of these particles can be controlled by reducing the particle size to a nano level, so that the absorption/fluorescence wavelength can be changed. In order to prevent S, Se, or the like from being removed by a reaction component of the matrix resin described later, the surface of the particle may be modified with a metal oxide such as silica or an organic substance, for example.
For example, the surface of the CdSe fine particle may be covered with a shell of a semiconductor material (e.g. ZnS) having a higher band gap energy. This allows to easily exhibit the confinement effect of electrons generated in the core particle.
The above-mentioned fine particles may be used either individually or in combination of two or more.
As examples of the organic fluorescent material fine particles, nanocrystal particles of an organic fluorescent dye containing a cyano group and having J-aggregation properties can be given.
The matrix resin is a resin for dispersing the fluorescent material fine particles. As the matrix resin, a non-curable resin, a heat-curable resin, or a photocurable resin may be used. Specific examples of the matrix resin include melamine resins, phenol resins, alkyd resins, epoxy resins, polyurethane resins, maleic resins, and polyamide resins, in the form of either an oligomer or a polymer; polymethyl methacrylate, polyacrylate, polycarbonate, polyvinyl alcohol, polyvinylpyrrolidone, hydroxyethylcellulose and carboxymethylcellulose, and copolymers containing monomers of which the above-mentioned polymers are formed, as the constituent components.
A photocurable resin may be used for patterning of the fluorescence conversion section. As the photocurable resin, a photopolymerizable resin generally containing a photosensitizer, such as an acrylic acid or methacrylic acid based resin having a reactive vinyl group, a photocrosslinkable resin such as polyvinyl cinnamate, or the like may be used. A heat-curable resin may be used when using no photosensitizer.

In a full color display, a fluorescence conversion section in which fluorescent material layers separated from one another are disposed in a matrix is formed. In this case, it is preferable to use the photocurable resin, which allows application of a photolithographic method, as the matrix resin.
The matrix resin may be used either individually or in combination of two or more.
The fluorescence conversion section is formed by using a dispersion liquid prepared by mixing and dispersing the fluorescent material fine particles and the matrix resin by a known method such as a milling method or an ultrasonic dispersion method. In this case, a good solvent for the matrix resin may be used. The resulting fluorescent material fine particle dispersion liquid is applied to a supporting substrate by a known application method such as a spin coating method or a screen printing method to form a fluorescence conversion section.
A known organic fluorescent material such as coumarins, rhodamines, fluoresceines, cyanines, porphyrins, naphthalimides, perylenes, or quinacridons may also be used in a state where the organic fluorescent material is dispersed in a polymer. As the polymer binder, a transparent resin such as polymethacrylate, polycarbonate, polyvinyl chloride, polyimide, polyamic acid, polyolefin, or polystyrene may be used.

6. Color filter

A color filter may be used for adjusting color purity, as required. Examples of materials for the color filter include dyes or solid objects in which the same dye is dissolved or dispersed in a binder resin. Examples of the die include copper phthalocyanine dyes, indanthrone dyes, indophenol dyes, cyanine dyes and dioxazin dyes. The die may be used alone or as a mixture of two or more kinds. Examples of the binder resin of the die include transparent resins (polymers) such as polymethyl methacrylate, polyacrylate, polycarbonate, polyvinyl alcohol, polyvinyl pyrrolidone, hydroxyethylcellulose, and carboxymethylcellulose. It can be used alone or as a mixture of two or more thereof. It is preferred to use, as the binder resin, a photosensitive resin to which photolithography can be applied. Examples of such a photosensitive resin include photo-setting resist materials having reactive vinyl groups such as acrylic acid type, methacrylic acid type, polyvinyl cinnamate type and cyclic rubber type. The photosensitive resin can be used alone or as a mixture of two or more kinds.

[Examples]

Example 1

(1) Formation of color conversion substrate

A pigment type red filter material (CRY-S840B, manufactured by FUJIFILM Arch Co., Ltd.) was spin-coated on a 0.7 mm thick glass plate. Thereafter, it was exposed to ultraviolet rays and baked at 200°C to obtain a red filter substrate (thickness of 1.2 μm).
A methacrylic acid-methyl methacrylate copolymer (the copolymerization ratio of methacrylic acid: 15 to 20%, Mw: 20000 to 25000) was used as a matrix resin. It was dissolved in 1-methoxy-2-acetoxypropane and CdSe nano particles with a particle diameter of 5.1 nm (fluorescence wavelength: 606 nm) was added thereto. The CdSe particles were added such that the weight ratio of the CdSe particles was 17.8 wt% relative to all solids.
The resultant mixture was spin-coated on the color filter film of the red filter prepared in the above substrate and dried at 200°C for 30 minutes to obtain a color conversion substrate wherein the red filter and color conversion film were stacked. The maximum wavelength at the excitation spectrum from 400 to 500 nm of the color conversion film was 400 nm and the thickness thereof was 17 μm.

(2) Fabrication of organic EL device

A 1.1 mm thick glass substrate (Corning 7059) was subjected to ultrasonic cleaning in isopropyl alcohol for 5 minutes followed by UV ozone cleaning for 30 minutes. The washed glass substrate was set up on a substrate holder in a vacuum deposition device.
Aluminum was sputtered to form a 300 nm thick film on the grass substrate. This aluminum film functioned as an anode and a first reflective member. ITO was sputtered to form a 10 nm thick film on the aluminum film. This ITO film functioned as a hole-injecting electrode (anode).
Next, a layer comprising the compound HI described below having a thickness of 20 nm was formed on the ITO film. This HI film functioned as a hole-injecting layer. A layer comprising the compound HT described below having a thickness of 15 nm was formed on the HI film. This HT film functioned as a hole-transporting layer.
Furthermore, the compound BH described below as a host material, and the compound BD described below as a dopant material were co-deposited on the HT film such that the ratio of BH to BD was 30 to 1.8, to form an emitting

layer (blue emitting layer) having a thickness of 30 nm.

A tris(8-quinolinol)aluminum (Alq) film was formed in a thickness of 10 nm thereon. This Alq film functioned as an electron-transporting layer. LiF was deposited on the Alq film in a thickness of 1 nm to form an electron-injecting cathode. Furthermore, an alloy film that comprised magnesium and silver in the ratio of magnesium to silver of 9 to 1 was formed in a thickness of 10 nm. This Mg:Ag film functioned as a metal cathode and a second reflective member. To form an upper transparent electrode (cathode), IZO was sputtered in a thickness of 75 nm. Finally as a sealing layer which covers the entire of the organic EL emitting parts, $SiO_xN_y$ (O/O+N=50%: atomic ratio) was deposited by low temperature CVD to form a 1000 nm-thick transparent inorganic film on the upper electrode (cathode) of the organic EL device, to obtain an organic EL device.

(3) Fabrication of organic EL display

The color conversion substrate obtained in the above (1) was arranged on the organic EL device fabricated in the above (2) such that the emitting surface of the organic EL device (sealing layer side) faced the film surface of the color conversion substrate. The periphery of the color conversion substrate was treated with a cationic photosetting type adhesive TB3102 (manufactured by Three Bond Co., Ltd.) and light-cured to fabricate an organic EL display.

(4) Evaluation of organic EL display

A voltage of 6.8 V was applied to the organic EL device obtained. The emission properties thereof were measured with a spectroradiometer (CS-1000, manufactured by Minolta Co., Ltd.) The blue peak wavelength was 469 nm, the luminance (L) was 999 nit and the chromaticity (CIE) was (0.134, 0.219).
The emission properties (6.8 V was applied) after the organic EL device was attached to the color conversion substrate were determined. The luminance-conversion efficiency (η) was 63%, the luminance was 625 nit and the chromaticity was (0.633, 0.364), and good red light was observed.
The luminance-conversion efficiency was obtained using the following equation.

$$\eta = [(\text{Luminance (nit) of an organic EL device attached to a color conversion substrate}) / (\text{Luminance (nit) of an organic EL device only})] \times 100$$

A constant current continuous driving test was conducted at room temperature while a current value was adjusted such that the luminance of red emission from the organic EL device thus obtained was 1000 nit. A period of time until the luminance was reduced by 40% (lifetime) (t60%) was 8860 hours.
Table 1 shows results.

Comparative Example 1

(1) Formation of color conversion substrate

A color conversion substrate was formed in the same way as in Example 1 (1)

(2) Fabrication of organic EL device

A 1.1 mm thick glass substrate (Corning 7059) was subjected to ultrasonic cleaning in isopropyl alcohol for 5 minutes followed by UV ozone cleaning for 30 minutes. The washed glass substrate was set up on a substrate holder in a vacuum deposition device.
ITO was sputtered to form a 130 nm thick film on the grass substrate. This ITO film functioned as a hole-injecting electrode (anode).

Next, a layer comprising the compound HI described below having a thickness of 60 nm was formed on the ITO film. This HI film functioned as a hole-injecting layer. A layer comprising the compound HT described below having a thickness of 20 nm was formed on the HI film. This HT film functioned as a hole-transporting layer.

Furthermore, the compound BH described below as a host material, and the compound BD described below as a dopant material were co-deposited on the HT film such that the ratio of BH to BD was 40 to 2.0, to form an emitting layer (blue emitting layer) having a thickness of 40 nm.

A tris(8-quinolinol)aluminum (Alq) film was formed in a thickness of 20 nm thereon. This Alq film functioned as an electron-transporting layer. LiF was deposited on the Alq film in a thickness of 1 nm to form an electron-injecting cathode. Furthermore, aluminum was sputtered to form a 300 nm thick film thereon as a metal cathode. Finally as a sealing layer which covered the entire of the organic EL emitting parts, $SiO_xN_y$ (O/O+N=50%: atomic ratio) was deposited by low temperature CVD to form a 1000 nm-thick transparent inorganic film on the upper electrode of the organic EL device, to obtain an organic EL device.

(3) Fabrication of organic EL display

The color conversion substrate obtained in the above (1) was arranged on the organic EL device fabricated in the above (2) such that the emitting surface of the organic EL device faced the film surface of the color conversion substrate. The periphery of the color conversion substrate was treated with a cationic photosetting type adhesive TB3102 (manufactured by Three Bond Co., Ltd.) and light-cured to fabricate an organic EL display.

(4) Evaluation of organic EL display

The organic EL display was evaluated in the same way as in Example 1. Table 1 shows results.
When a voltage of 6.8 V was applied to the organic EL device obtained, the blue peak wavelength was 472 nm, the luminance (L) was 1205 nit and the chromaticity (CIE) was (0.167, 0.325).
The emission properties (6.8 V was applied) after the organic EL device was attached to the color conversion substrate were that the luminance-conversion efficiency (η) was 46%, the luminance was 552 nit and the chromaticity was (0.630, 0.367). The luminance-conversion efficiency was 80% or less of that of Example 1 and the luminance was 90% or less of that of Example 1.
A constant current continuous driving test was conducted at room temperature while a current value was adjusted such that the luminance of red emission from the organic EL device thus obtained was 1000 nit. A period of time until the luminance was reduced by 40% (lifetime) (t60%) was 5547 hours. The period was 60% or less of that of Example 1.
Table 1

| | EL | | | EL / CCM | | | | |
|---|---|---|---|---|---|---|---|---|
| | CIEx | CIEy | L | η | CIEx | CIEy | L | t60% |
| Example 1 | 0.134 | 0.219 | 999 | 63 | 0.633 | 0.364 | 625 | 8860 |
| Comparative Example 1 | 0.167 | 0.325 | 1205 | 46 | 0.630 | 0.367 | 552 | 5547 |

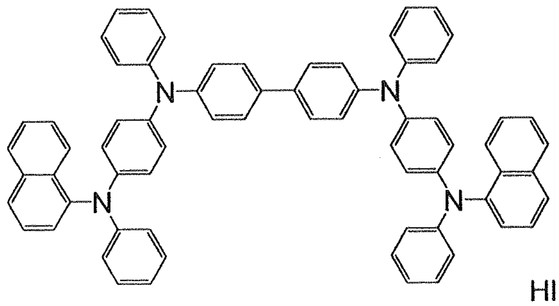

HI

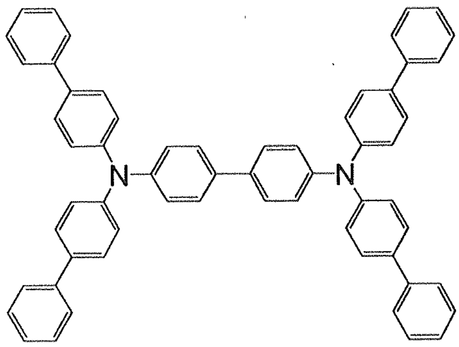

HT

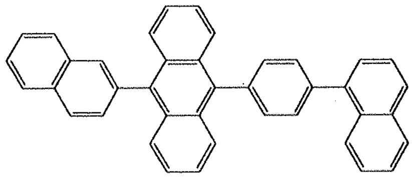

BH

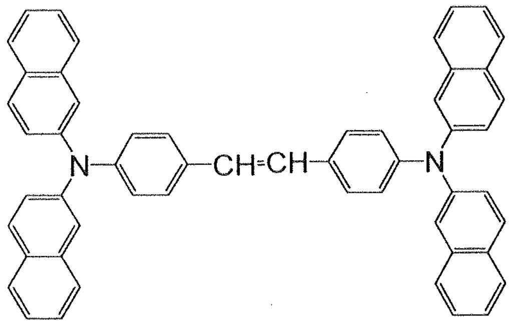

BD

Industrial Applicability

The organic EL device of the invention can be used for various kinds of displays such as consumer TVs, large displays and displays for cellular phones.

## Claims

**1.** An organic electroluminescent display comprising:

an organic electroluminescent device including an organic luminescent medium which emits light having an emission peak wavelength λ1 of 400 to 500 nm, and a first reflecting member and a second reflecting member disposed with the organic luminescent medium placed therebetween; and
a fluorescence conversion section which absorbs the light emitted from the organic electroluminescent device and emits light having a wavelength differing from the wavelength of the light emitted from the organic electroluminescent device, the fluorescence conversion section having a maximum wavelength of λ2 in a range of 400 to 500 nm in an excitation spectrum;
light emitted from the organic electroluminescent device being subjected to optical interference between the first reflecting member and the second reflecting member so that an emission component having a wavelength λ3, which is closer to the wavelength λ2 than the wavelength λ1, is enhanced and emitted from the organic

electroluminescent device.

2. The organic electroluminescent display according to claim 1, wherein the fluorescence conversion section includes an inorganic fluorescent material.

3. An organic electroluminescent display comprising: a blue pixel including,
a first organic electroluminescent device including an organic luminescent medium which emits blue light having an emission peak wavelength of λb;
a green pixel including,
a second organic electroluminescent device including an organic luminescent medium which emits blue light having an emission peak wavelength of λb, and a first reflecting member and a second reflecting member disposed with the organic luminescent medium placed therebetween and forming a first optical thickness, and
a green fluorescence conversion section which absorbs the blue light emitted from the second organic electroluminescent device and emits green light, the green fluorescence conversion section having a maximum peak wavelength in an excitation spectrum of λg,
light emitted from the organic luminescent medium being subjected to optical interference between the first reflecting member and the second reflecting member so that an emission component having a wavelength λb1, which is closer to the wavelength λg than the wavelength λb, is enhanced and emitted from the second organic electroluminescent device; and
a red pixel including,
a third organic electroluminescent device including an organic luminescent medium which emits blue light having an emission peak wavelength of λb, and a first reflecting member and a second reflecting member disposed with the organic luminescent medium placed therebetween and forming a second optical thickness, and
a red fluorescence conversion section which absorbs the blue light emitted from the third organic electroluminescent device and emits red light, the red fluorescence conversion section having a maximum peak wavelength in an excitation spectrum of λr,
light emitted from the organic luminescent medium being subjected to optical interference between the first reflecting member and the second reflecting member so that an emission component having a wavelength λb2, which is closer to the wavelength λr than the wavelength λb, is enhanced and emitted from the third organic electroluminescent device.

4. The organic electroluminescent display according to claim 3, wherein the red fluorescence conversion section and the green fluorescence conversion include an inorganic fluorescent material.

5. The organic electroluminescent display according to claim 3, comprising an optical thickness adjustment layer between the first reflecting member and the second reflecting member forming the first optical thickness or between the first reflecting member and the second reflecting member forming the second optical thickness.

6. An organic electroluminescent display comprising:

a blue pixel including,
a first organic electroluminescent device including an organic luminescent medium which emits blue light having an emission peak wavelength of λb, and a first reflecting member and a second reflecting member disposed with the organic luminescent medium placed therebetween and forming a first optical thickness,
light emitted from the organic luminescent medium being subjected to optical interference between the first reflecting member and the second reflecting member so that a blue emission component is enhanced and emitted from the first organic electroluminescent device;
a green pixel including,
a second organic electroluminescent device including an organic luminescent medium which emits blue light having an emission peak wavelength of λb, and a first reflecting member and a second reflecting member disposed with the organic luminescent medium placed therebetween and forming a second optical thickness, and
a green fluorescence conversion section which absorbs the blue light emitted from the second organic electroluminescent device and emits green light, the green fluorescence conversion section having a maximum peak wavelength in an excitation spectrum of λg,
light emitted from the organic luminescent medium being subjected to optical interference between the first reflecting member and the second reflecting member so that an emission component having a wavelength λb1, which is closer to the wavelength λg than the wavelength λb, is enhanced and emitted from the second organic electroluminescent device; and

a red pixel including,
a third organic electroluminescent device including an organic luminescent medium which emits blue light having an emission peak wavelength of λb, and a first reflecting member and a second reflecting member disposed with the organic luminescent medium placed therebetween and forming a third optical thickness, and
a red fluorescence conversion section which absorbs the blue light emitted from the third organic electroluminescent device and emits red light, the red fluorescence conversion section having a maximum peak wavelength in an excitation spectrum of λr,
light emitted from the organic luminescent medium being subjected to optical interference between the first reflecting member and the second reflecting member so that an emission component having a wavelength λb2, which is closer to the wavelength λr than the wavelength λb, is enhanced and emitted from the third organic electroluminescent device.

**7.** The organic electroluminescent display according to claim 6, wherein the red fluorescence conversion section and the green fluorescence conversion include an inorganic fluorescent material.

**8.** The organic electroluminescent display according to claim 6, comprising a first optical thickness adjustment layer between the first reflecting member and the second reflecting member forming the second optical thickness, and a second optical thickness adjustment layer between the first reflecting member and the second reflecting member forming the third optical thickness.

**9.** The organic electroluminescent display according to any of claims 1 to 8, further comprising a substrate, the organic electroluminescent display being a top emission type in which light is taken out from a side opposite to the substrate.

**10.** The organic electroluminescent display according to any of claims 1 to 8, further comprising a substrate, the organic electroluminescent display being a bottom emission type in which light is taken out from a side of the substrate.

FIG. 1

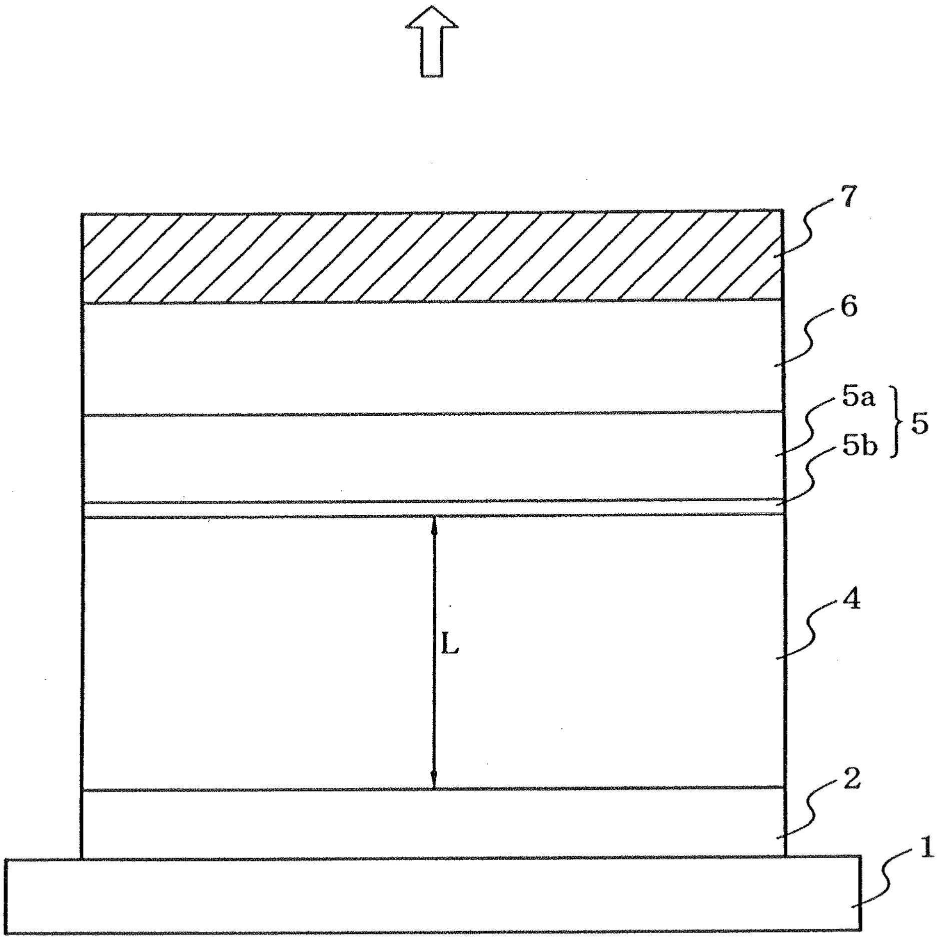

FIG. 2(a)

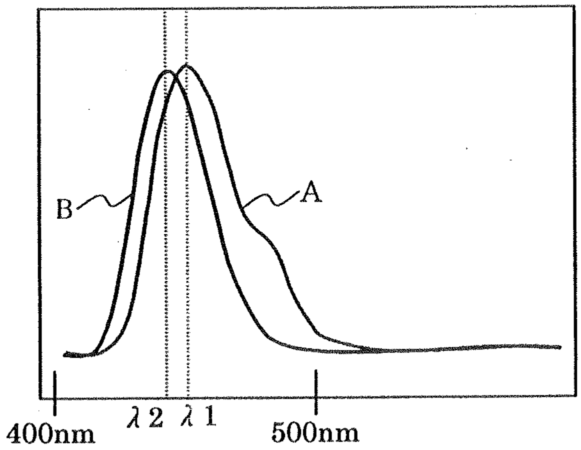


FIG. 2(b)

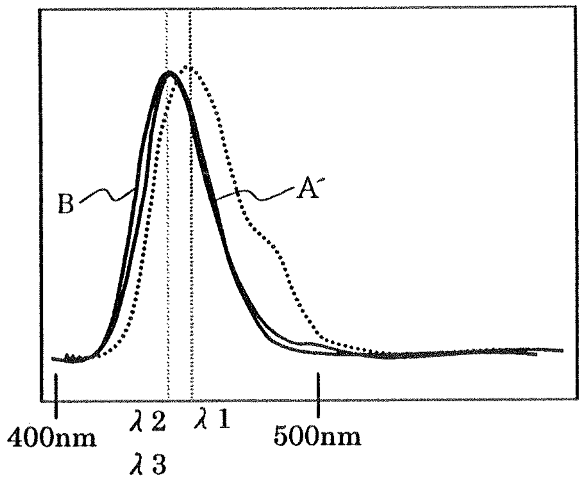

FIG. 3

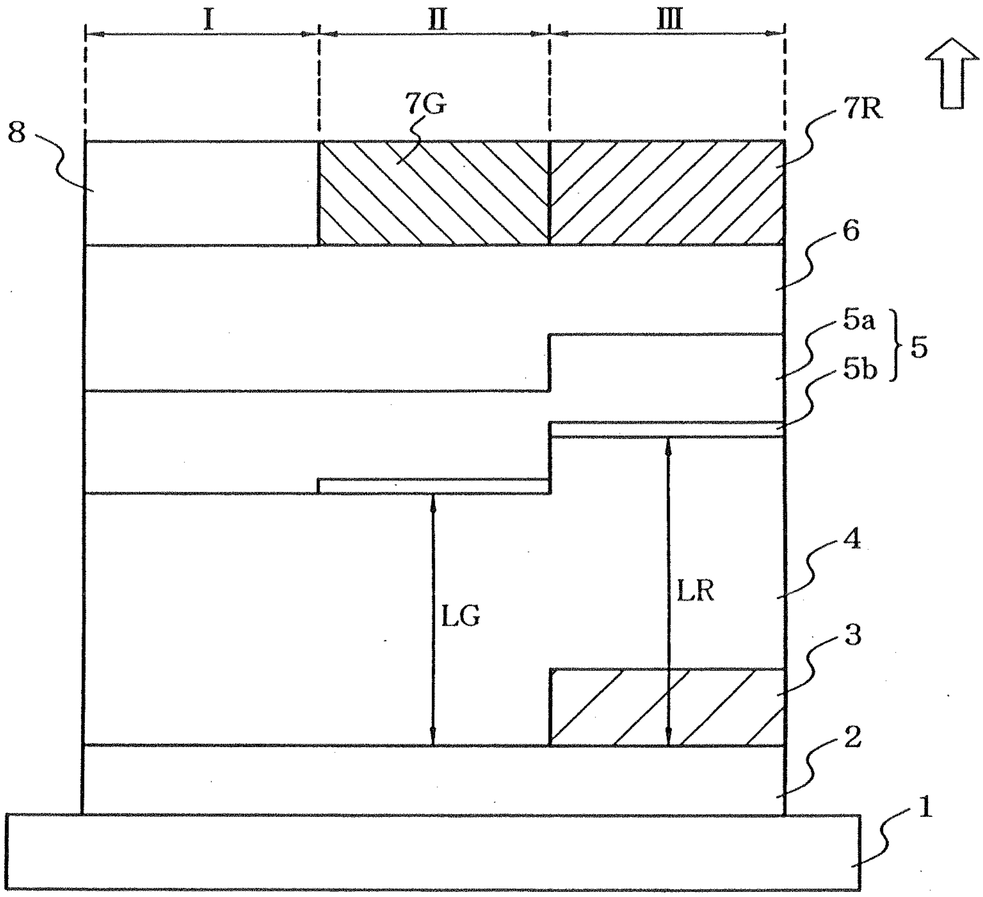

FIG. 4

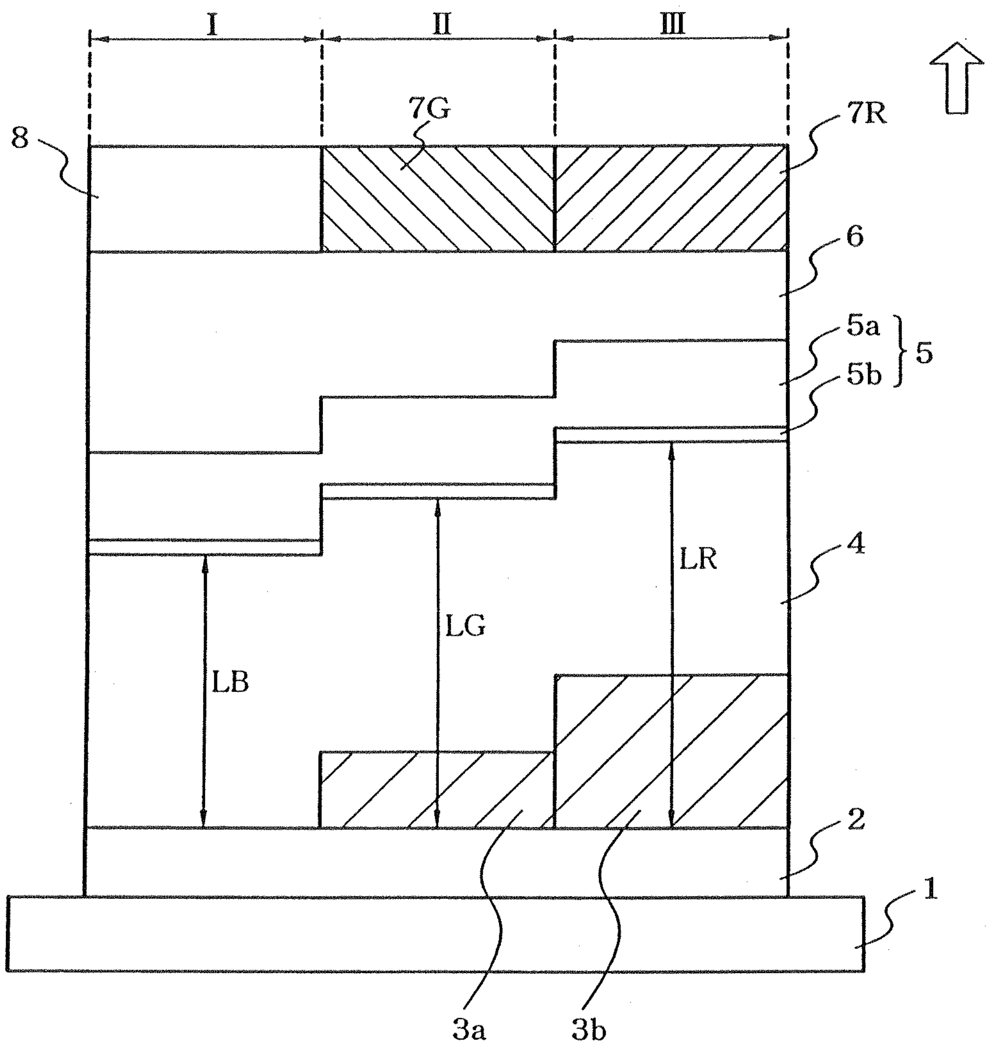

FIG. 5

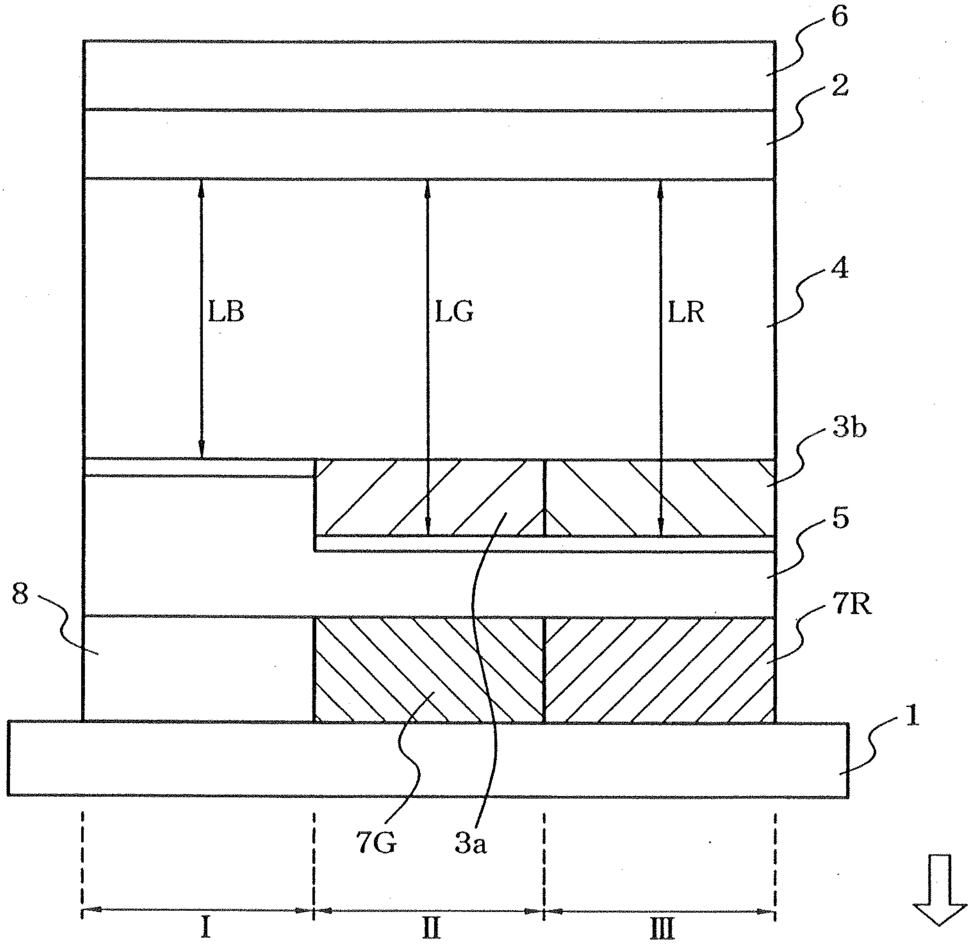

## INTERNATIONAL SEARCH REPORT

International application No.
PCT/JP2005/012666

A. CLASSIFICATION OF SUBJECT MATTER
Int.Cl[7] H05B33/24, 33/12, 33/14

According to International Patent Classification (IPC) or to both national classification and IPC

B. FIELDS SEARCHED

Minimum documentation searched (classification system followed by classification symbols)
Int.Cl[7] H05B33/24, 33/12, 33/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2001-210471 A (Motorola, Inc.), 03 August, 2001 (03.08.01), Claims 1 to 2; Figs. 2 to 3; Par. Nos. [0013] to [0015] & EP 1124274 A1 | 1-10 |
| X | JP 2002-520801 A (Motorola, Inc.), 09 July, 2002 (09.07.02), Claims 1 to 2 & US 2000/6140764 A1 & WO 2000/04594 A1 | 1-10 |
| A | JP 2002-359076 A (Konica Corp.), 13 December, 2002 (13.12.02), Par. No. [0049] (Family: none) | 1-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 September, 2005 (02.09.05) | 20 September, 2005 (20.09.05) |
| Name and mailing address of the ISA/ Japanese Patent Office | Authorized officer |
| Facsimile No. | Telephone No. |

Form PCT/ISA/210 (second sheet) (January 2004)

INTERNATIONAL SEARCH REPORT

International application No.
PCT/JP2005/012666

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2004-14335 A (Konica Minolta Holdings Kabushiki Kaisha), 15 January, 2004 (15.01.04), Full text; all drawings (Family: none) | 2,4,7 |
| P,A | JP 2005-129510 A (Sanyo Electric Co., Ltd.), 19 May, 2005 (19.05.05), Claim 6; Par. Nos. [0036] to [0060] (Family: none) | 1-10 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6501091 B
- JP 2002510866 A